# EUROPÄISCHE PATENTANMELDUNG

(11) **EP 3 457 147 A1**
(43) Veröffentlichungstag der Anmeldung: **20.03.2019**
(21) Anmeldenummer: 17190903.9
(22) Anmeldetag: 13.09.2017
(51) Int. Cl.: G01R 15/16, G01R 19/17

(54) **VORRICHTUNG ZUR ERFASSUNG EINER ANZAHL VON TRANSIENTEN SPANNUNGSIMPULSEN**

(71) Anmelder: Siemens Aktiengesellschaft, 80333 München (DE)
(72) Erfinder: Bethge, Andreas, 13587 Berlin (DE); Greinacher, Moritz, 14197 Berlin (DE); Obralic, Alija, 10437 Berlin (DE)

(57) **Zusammenfassung**

Die Erfindung betrifft eine Vorrichtung (39) zur Erfassung einer Anzahl von transienten Spannungsimpulsen, insbesondere auf einer Spannungsversorgung. Um eine Vorrichtung für Spannungen im Kilovoltbereich anzugeben, die, im Vergleich zum Stand der Technik, einfach, robust und kostengünstig ist, wird vorgeschlagen, dass sie einen Stützisolator (34) mit wenigstens einem ersten Anschluss (46) und einem Messanschluss (52) aufweist, wobei wenigstens ein erster Kondensator (54) zwischen dem ersten Anschluss (46) und dem Messanschluss (52) angeschlossen ist und wobei eine Überwachungsvorrichtung (40) am Messanschluss (52) kontaktiert ist, welche eine Zählvorrichtung (66) zur Erfassung einer Anzahl von Spannungsimpulsen oberhalb einer vorgegebenen Spannungsschwelle umfasst.

## Beschreibung

Die Erfindung betrifft eine Vorrichtung zur Erfassung einer Anzahl von transienten Spannungsimpulsen, insbesondere auf einer Spannungsversorgung.

Die Erfindung betrifft darüber hinaus eine elektrische rotierende Maschine mit mindestens einer derartigen Vorrichtung.

Ferner betrifft die Erfindung ein Verfahren zur Erfassung einer Anzahl von Spannungsimpulsen, insbesondere auf einer Spannungsversorgung.

Die Erfindung betrifft des Weiteren eine Steuervorrichtung zur Durchführung eines derartigen Verfahrens.

Eine derartige Vorrichtung wird insbesondere in elektrischen rotierenden Maschinen, beispielsweise Motoren oder Generatoren, mit einer Leistung von mindestens 1 MW verwendet, wobei eine solche elektrische rotierende Maschine eine Versorgungsspannung von mindestens 1 kV, beispielsweise 6,6 kV, aufweist. Eine der häufigsten Ursache von Ausfällen in derartigen elektrischen rotierenden Maschinen sind Wicklungsschäden an einer Statorwicklung. Derartige Wicklungsschäden werden oft durch unzulässig hohe transiente Spannungsimpulse verursacht, deren Ursprung sich außerhalb der elektrischen rotierenden Maschine, beispielsweise in einem elektrischen Versorgungsnetz des Maschinenbetreibers befindet. Ein solcher transienter Spannungsimpuls weist beispielsweise eine Spitzenspannung auf, die im Bereich des Zehnfachen der Betriebsspannung liegt. Ursachen für derartige Spannungsimpulse sind beispielsweise eine schlechte Auslegung des Netzes und/oder dessen Topologie, Schalthandlungen und/oder Schaltsequenzen sowie eine unzureichende Schutzbeschaltung. Für den Betrieb der elektrischen rotierenden Maschine unzulässige Spannungsimpulse sind beispielsweise über konventionelle U-/I-/P-Messschreiber aufgrund der kurzen Dauer der Spannungspulse nicht registrierbar, da die verwendeten Messgeräte eine zu geringe Abtastrate aufweisen.

Die Offenlegungsschrift GB 2 231 672 A1 beschreibt einen Detektor zum Erfassen von Spikes auf einer Netzstromversorgung und zum Zählen der Anzahl von Spikes, die während eines Zeitraums auftreten. Der Detektor umfasst eine Zenerdiode, die in Reihe mit einem Widerstand geschaltet ist, und einen Zähler mit einem Eingang, der über den Widerstand verbunden ist. Die Zenerdiode und der Widerstand sind in Reihe mit der Netzversorgung verbunden.

Die Offenlegungsschrift DE 102 13 532 A1 beschreibt einen Stützisolator mit einem Fußbereich, mit wenigstens einem Messanschluss, mit wenigstens einem ersten Anschluss und einem zweiten Anschluss, und mit wenigstens einem Kondensator, dessen einer Pol an dem ersten Anschluss und dessen zweiter Pol an den Messanschluss angeschlossen ist. Ein derartiger Stützisolator kommt auf dem Gebiet der elektrischen Maschinen zum Einsatz.

Der Erfindung liegt die Aufgabe zugrunde, eine Vorrichtung zur Erfassung einer Anzahl von transienten Spannungsimpulsen, insbesondere auf einer Spannungsversorgung, für Spannungen im Kilovoltbereich anzugeben, welche, im Vergleich zum Stand der Technik, einfach, robust und kostengünstig ist.

Diese Aufgabe wird erfindungsgemäß durch eine Vorrichtung zur Erfassung einer Anzahl von transienten Spannungsimpulsen, insbesondere auf einer Spannungsversorgung, gelöst, welche einen Stützisolator mit wenigstens einem ersten Anschluss und einem Messanschluss aufweist, wobei wenigstens ein erster Kondensator zwischen dem ersten Anschluss und dem Messanschluss angeschlossen ist und wobei eine Überwachungsvorrichtung am Messanschluss kontaktiert ist, welche eine Zählvorrichtung zur Erfassung einer Anzahl von Spannungsimpulsen oberhalb einer vorgegebenen Spannungsschwelle umfasst.

Ferner wird die Aufgabe erfindungsgemäß durch eine elektrische rotierende Maschine mit mindestens einer derartigen Vorrichtung gelöst.

Darüber hinaus wird die Aufgabe erfindungsgemäß durch ein Verfahren zur Erfassung einer Anzahl von transienten Spannungsimpulsen, insbesondere auf einer Spannungsversorgung, an einem Stützisolator, gelöst, welcher wenigstens einen ersten Anschluss und einen Messanschluss aufweist, wobei wenigstens ein erster Kondensator zwischen dem ersten Anschluss und dem Messanschluss angeschlossen ist, wobei eine Überwachungsvorrichtung am Messanschluss kontaktiert wird, welche eine Zählvorrichtung umfasst, wobei von der Zählvorrichtung eine Anzahl von Spannungspulsen, welche einen vorgegebenen Wert überschreiten, ermittelt wird.

Überdies wird die Aufgabe erfindungsgemäß durch eine Steuervorrichtung zur Durchführung eines derartigen Verfahrens gelöst.

Die in Bezug auf die Vorrichtung nachstehend angeführten Vorteile und bevorzugten Ausgestaltungen lassen sich sinngemäß auf die elektrische rotierende Maschine, das Verfahren und die Steuervorrichtung übertragen.

Der Erfindung liegt die Überlegung zugrunde, unzulässig hohe transiente Spannungsimpulse, auch Stoßspannungen genannt, die häufig für Wicklungsschäden in einer elektrischen rotierenden Maschine verantwortlich sind, beispielsweise auf einer Versorgungsspannung, nachzuweisen und zu zählen. Die elektrische rotierende Maschine ist insbesondere mit einer Betriebsspannung ab 1 kV, beispielsweise mit 6,6 kV, betreibbar, wobei eine Stoßspannung zumindest kurzzeitig einen mehr als zehnfachen Wert der Nennspannung annehmen kann. Dazu wird ein Stützisolator herangezogen, welcher insbesondere in einem Klemmkasten angeordnet ist. Beispielsweise ist ein Stützisolator pro Phase im Klemmkasten angeordnet. Der Stützisolator weist einen Kondensator mit einer Kapazität im Bereich von 100 pF bis 500 pF auf, an dem ein Großteil der Betriebsspannung abfällt. An einem Messanschluss des Stützisolators wird eine Überwachungsvorrichtung kontaktiert, welche mit Hilfe einer Zählvorrichtung eine Anzahl von Spannungsimpulsen oberhalb einer vorgegebenen Spannungsschwelle erfasst. Da, insbesondere bei einer vergleichsweise niedrigen Eingangsimpedanz des Zählers, ein Großteil der Spannung am Kondensator des ohnehin zur mechanischen Abstützung von Stromschienen im Klemmkasten angebrachten Stützisolators abfällt, ist ein einfacher und kostengünstiger Zähler, welcher beispielsweise für Spannungen von maximal 50 V geeignet ist, verwendbar. Beispielsweise ist die Überwachungsvorrichtung über eine einfache Steckverbindung lösbar mit dem Stützisolator kontaktierbar. Eine derartige Vorrichtung zum Zählen von unzulässig hohen transienten Spannungsimpulsen ist einfach, robust und insbesondere durch die Nutzung ohnehin vorhandener Komponenten kostengünstig.

In einer bevorzugten Ausgestaltung umfasst der Stützisolator einen zweiten Anschluss, wobei wenigstens eine Überspannungsschutzkomponente zwischen dem Messanschluss und dem zweiten Anschluss angeschlossen ist. Insbesondere ist die Überspannungsschutzkomponente in Serie zum ersten Kondensator und parallel zur Überwachungsvorrichtung geschaltet. Die Überspannungsschutzkomponente umfasst beispielsweise eine Suppressordiode, welche insbesondere als bidirektionale TVS-Diode ausgeführt ist. Die TVS-Diode weist beispielsweise eine maximale Spitzen-Puls-Verlustleistung im Bereich von 1 bis 3 kW sowie eine Durchbruchspannung von 10 bis 50 V auf. Optional umfasst die Überspannungsschutzkomponente einen zusätzlichen in Serie zur Suppressordiode geschalteten Widerstand. Der Widerstand liegt beispielsweise im Bereich von 200 bis 800 Ohm. Wird eine Spannungsschwelle überschritten, wird die Überspannungsschutzkomponente leitfähig und begrenzt die Spannung. Durch die Überspannungsschutzkomponente wird eine Gefährdung einer an den Messanschluss geschalteten Elektronik und/oder einer in der Umgebung befindlichen Person vermieden.

In einer weiteren vorteilhaften Ausführungsform ist die wenigstens eine Überspannungsschutzkomponente in den Stützisolator integriert. Insbesondere ist die Überspannungsschutzkomponente derartig in einen Fußbereich des Stützisolators integriert, dass sie zwischen dem Messanschluss und dem zweiten Anschluss, der sich beispielsweise an der Innenseite der Befestigungsbohrung befindet, mittels Leitungen geschaltet ist. Durch die Integration der wenigstens einen Überspannungsschutzkomponente reduziert sich eine Anzahl von Teilkomponenten und somit auch der Platzbedarf.

In einer bevorzugten Ausgestaltung weist die Überwachungsvorrichtung Mittel zur Zuweisung eines Zeitstempels zu den jeweiligen Spannungsimpulsen auf. Der Zeitstempel ist beispielsweise ein Datum, optional mit einer Uhrzeit, welches in der Überwachungsvorrichtung ermittelt oder, beispielsweise kontaktlos, über eine Kommunikationsschnittstelle übertragen wird. Eine Zuweisung des Zeitstempels erfolgt über digitale Signalverarbeitung, beispielsweise über einen Mikrocontroller. Mit Hilfe eines Zeitstempels und des Zählstandes wird eine Häufigkeit von unzulässig hohen Stoßspannungen ermittelt.

Besonders vorteilhaft umfasst die Zählvorrichtung einen zweiten Kondensator, welcher mit dem ersten Kondensator einen kapazitiven Spannungsteiler bildet. Der zweite Kondensator weist eine Kapazität im Bereich von 1 µF bis 10 µF auf. Über das Verhältnis der Kapazitätswerte ist eine Eingangsspannung der Zählvorrichtung skalierbar, wobei die maximale Eingangsspannung beispielsweise bei 40 V liegt.

In einer weiteren vorteilhaften Ausführungsform umfasst die Zählvorrichtung Mittel zur digitalen Signalverarbeitung. Die Mittel zur digitalen Signalverarbeitung sind insbesondere digitale Schaltungen, welche beispielsweise in einem Mikrocontroller integriert sind. Insbesondere integrierte digitale Schaltungen sind klein, stromsparend und kostengünstig.

Besonders vorteilhaft umfassen die Mittel zur digitalen Signalverarbeitung einen Schmitt-Trigger und/oder einen Komparator. Ein Schmitt-Trigger und ein Komparator sind einfache, stromsparende und kostengünstige Schaltungen, um eindeutige Schaltzustände aus einem analogen Eingangssignalverlauf zu gewinnen. Der Schmitt-Trigger ist eine elektronische Komparator-Schaltung, bei der eine Einschaltschwelle und eine Ausschaltschwelle nicht zusammenfallen, sondern um eine bestimmte Spannung gegeneinander versetzt sind. Durch eine derartige Schalthysterese werden schnelle Amplitudenänderungen, insbesondere Schwingungen, innerhalb eines transienten Spannungsimpulses, beispielsweise überlagernde Störsignale und/oder Rauschen, geglättet.

In einer bevorzugten Ausgestaltung weist die Überwachungsvorrichtung eine Datenspeichervorrichtung und/oder eine Energiespeichervorrichtung auf. Insbesondere ist die Datenspeichervorrichtung als Halbleiterspeicher ausgeführt, welche drahtlos und/oder bedrahtet auslesbar ist. Ein Halbleiterspeicher ist kostengünstig und sehr klein. Die Energiespeichervorrichtung ist beispielsweise als Batterie oder Akku ausgeführt, welche insbesondere Lithium enthält. Insbesondere eine Lithium enthaltende Batterie weist eine hohe Energiedichte und geringe Selbstentladung auf, wodurch eine Laufzeit im Bereich von 10 Jahren erzielbar ist.

Vorteilhaft ist die Überwachungsvorrichtung über eine Steckverbindung lösbar kontaktiert. Insbesondere ist die Überwachungsvorrichtung über eine Steckverbindung an einem PC auslesbar. Optional wird zum Auslesen ein Auslesegerät verwendet. Eine derartige Steckverbindung gewährleistet eine schnelle und einfache Übertragung von ermittelten Daten.

Im Folgenden wird die Erfindung anhand der in den Figuren dargestellten Ausführungsbeispiele näher beschrieben und erläutert.

Es zeigen:
- FIG 1: eine schematische Darstellung einer elektrischen rotierenden Maschine,
- FIG 2: einen Längsschnitt einer Vorrichtung zur Erfassung einer Anzahl von transienten Spannungsimpulsen,
- FIG 3: ein Blockschaltbild einer Vorrichtung zur Erfassung einer Anzahl von transienten Spannungsimpulsen,
- FIG 4: ein Blockschaltbild einer Vorrichtung zur Erfassung einer Anzahl von transienten Spannungsimpulsen für eine Spannungsversorgung mit drei Phasen und
- FIG 5: eine Schaltungsanordnung einer Zählvorrichtung einer Überwachungsvorrichtung.

Gleiche Bezugszeichen haben in den verschiedenen Figuren die gleiche Bedeutung.

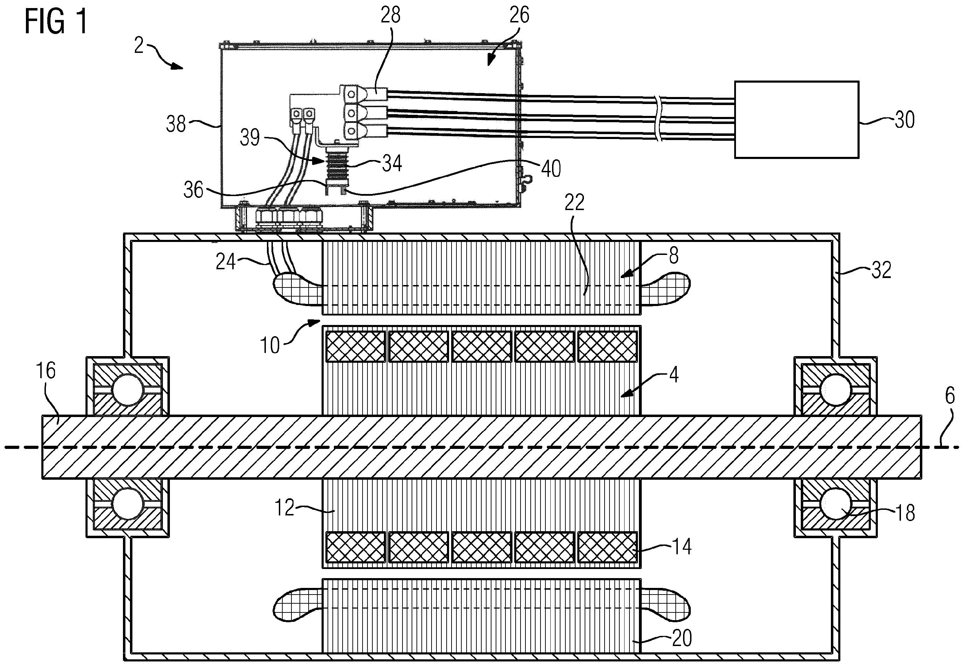

FIG 1 zeigt einen Längsschnitt einer elektrischen rotierenden Maschine 2, die einen Rotor 4, der um eine Rotationsachse 6 rotierbar ist, und einen den Rotor 4 umgebenden Stator 8 aufweist. Zwischen dem Rotor 4 und dem Stator 8 befindet sich ein Spalt 10, der bevorzugt als Luftspalt ausgeführt ist. Die Rotationsachse 6 definiert eine Axialrichtung, eine Radialrichtung und eine Umfangsrichtung. Die elektrische rotierende Maschine 2 ist exemplarisch als Synchronmaschine ausgeführt und weist ein Rotorblechpaket 12 mit Permanentmagneten 14 auf. Das Rotorblechpaket 12 ist drehfest mit einer Welle 16 verbunden, die über in Axialrichtung beidseitig angeordnete Lager 18 gelagert ist. Der Stator 8 weist ein Statorblechpaket 20 mit einer Statorwicklung 22 auf. Ein Wicklungsanschluss 24 der elektrischen rotierenden Maschine 2 ist über einen in einem Klemmkasten 26 angeordneten Netzanschluss 28 mit einer dreiphasigen Spannungsversorgung 30 verbunden. Pro Phase ist im Klemmkasten 26, welcher auf einem Maschinengehäuse 32 der elektrischen rotierenden Maschine 2 aufliegt, zumindest ein aus einem Gießharz hergestellter Stützisolator 34 angeordnet, wobei die Stützisolatoren 34 über eine, insbesondere metallische, Schiene 36, welche beispielsweise als L-Profil-Schiene ausgeführt ist, mit einem geerdeten Gehäuse 38 des Klemmkastens 26 verbunden sind. Eine Vorrichtung 39 zur Erfassung einer Anzahl von transienten Spannungsimpulsen wird durch den vorhandenen Stützisolator 34 und eine Überwachungsvorrichtung 40 gebildet, die lösbar mit dem Stützisolator 34 verbunden ist.

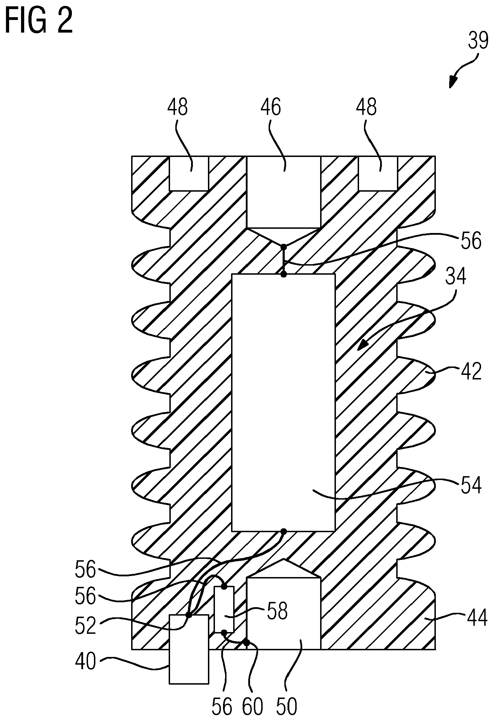

FIG 2 zeigt einen Längsschnitt einer Vorrichtung 39 zur Erfassung einer Anzahl von transienten Spannungsimpulsen mit einem Stützisolator 34 und einer Überwachungsvorrichtung 40. Der zylindrisch ausgebildete und mit Rippen 42 versehene Stützisolator 34 weist einen Fußbereich 44, einen ersten Anschluss 46, welcher als Potentialanschlussbuchse ausgebildet ist, sowie Arretierungsbohrungen 48 auf. Im Fußbereich 44 sind weiterhin eine Befestigungsbohrung 50 und ein Messanschluss 52, welcher als Messbuchse ausgebildet ist, angeordnet. In den Stützisolator 34 ist ferner ein erster Kondensator 54 integriert, welcher über Leitungen 56 zwischen dem ersten Anschluss 46 und dem Messanschluss 52 elektrisch kontaktiert ist. Insbesondere weist der erste Kondensator 54 eine Kapazität im Bereich von 100 pF bis 500 pF auf. Des Weiteren ist eine Überspannungsschutzkomponente 58 derartig im Fußbereich 44 des Stützisolators 34 integriert, dass sie zwischen dem Messanschluss 52 und einem zweiten Anschluss 60, der sich an der Innenseite der Befestigungsbohrung 50 befindet, mittels Leitungen 56 geschaltet ist. Die Überwachungsvorrichtung 40 ist über eine Steckverbindung lösbar mit dem Messanschluss 52 des Stützisolators 34 kontaktiert. Die weitere Ausführung der Vorrichtung 39 in FIG 2 entspricht der in FIG 1.

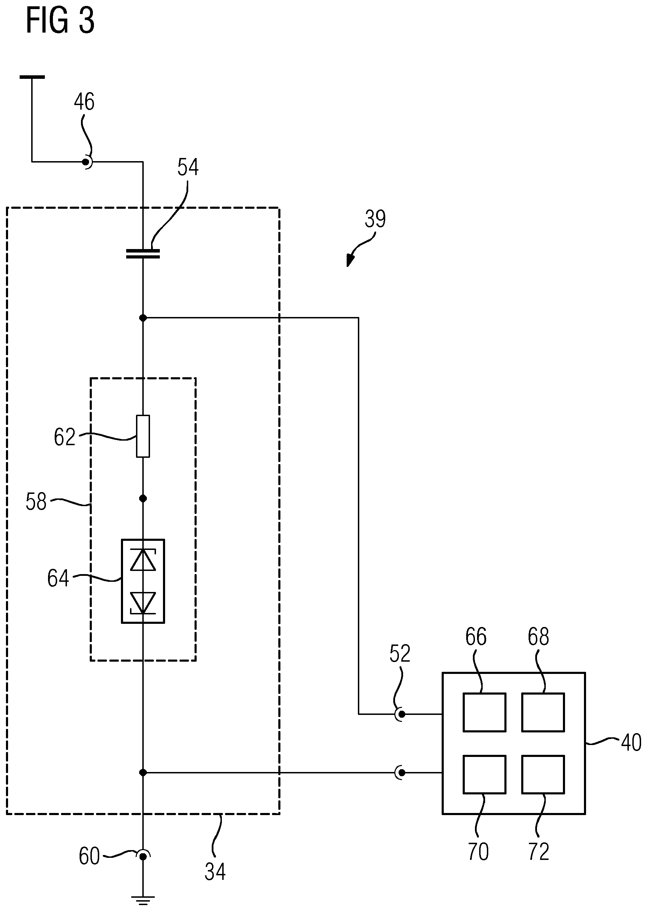

FIG 3 zeigt ein Blockschaltbild einer Vorrichtung 39 zur Erfassung einer Anzahl von transienten Spannungsimpulsen mittels eines Stützisolators 34 und einer mit dem Stützisolator 34 verbundenen Überwachungsvorrichtung 40. Der erste Kondensator 54 ist zwischen dem ersten Anschluss 46 und dem Messanschluss 52 geschaltet, wobei, in Serie zum ersten Kondensator 54, zwischen dem Messanschluss 52 und dem zweiten Anschluss 60 die Überspannungsschutzkomponente 58 geschaltet ist. Die Überspannungsschutzkomponente 58 weist eine Serienschaltung von einem Widerstand 62 und einer Suppressordiode 64, welche in FIG 3 als, insbesondere bidirektionale, TVS-Diode ausgeführt ist, auf. Der Widerstand liegt im Bereich von 200 bis 800 Ohm. Die TVS-Diode weist beispielsweise eine maximale Spitzen-Puls-Verlustleistung im Bereich von 1 bis 3 kW sowie eine Durchbruchspannung von 10 bis 50 V auf. Ebenfalls in Serie zum ersten Kondensator 54 und parallel zur Überspannungsschutzkomponente 58 ist die Überwachungsvorrichtung 40 am Messanschluss 52 angeschlossen, wobei die Überwachungsvorrichtung 40 eine Zählvorrichtung 66 zur Erfassung einer Anzahl von Spannungsimpulsen oberhalb einer vorgegebenen Spannungsschwelle, eine Datenspeichervorrichtung 68, eine Energiespeichervorrichtung 70 sowie eine Steuervorrichtung 72 umfasst. Die Datenspeichervorrichtung 68 ist insbesondere als elektronischer Datenspeicher ausgeführt, wobei die Überwachungsvorrichtung 40 direkt oder über ein Auslesegerät mit einem Computer verbindbar und der elektronische Datenspeicher über den Computer auslesbar ist. Alternativ ist die Datenspeichervorrichtung 68 kontaktlos, beispielsweise über Bluetooth, auslesbar. Die Energiespeichervorrichtung 70 ist als Batterie oder Akku, insbesondere als Lithium aufweisende Batterie, ausgeführt, welche einen Betrieb über mehrere Jahre gewährleistet. Zusätzlich oder alternativ wird der Überwachungsvorrichtung 40 Energie durch Energy-Harvesting bereitgestellt. Die weitere Ausführung der Vorrichtung 39 in FIG 3 entspricht der in FIG 2.

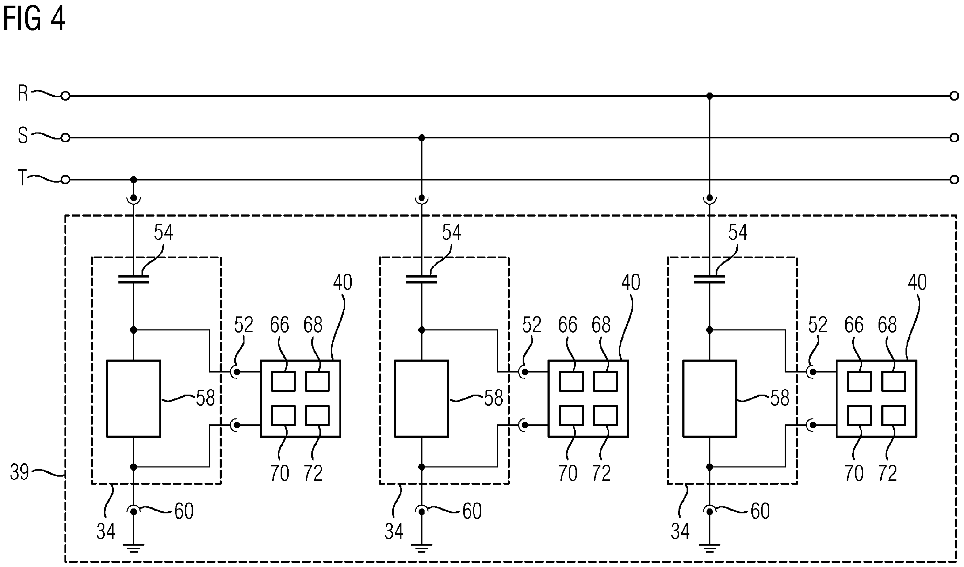

FIG 4 zeigt ein Blockschaltbild einer Vorrichtung 39 zur Erfassung einer Anzahl von transienten Spannungsimpulsen für eine Spannungsversorgung mit drei Phasen R, S, T. Die Vorrichtung 39 weist für die drei Phasen R, S, T jeweils einen Stützisolator 34 mit einer Überwachungsvorrichtung 40, welcher wie in FIG 3 ausgeführt ist, auf. Zwischen den drei Phasen R, S, T und Erde sind die jeweiligen Stützisolatoren 34 geschaltet.

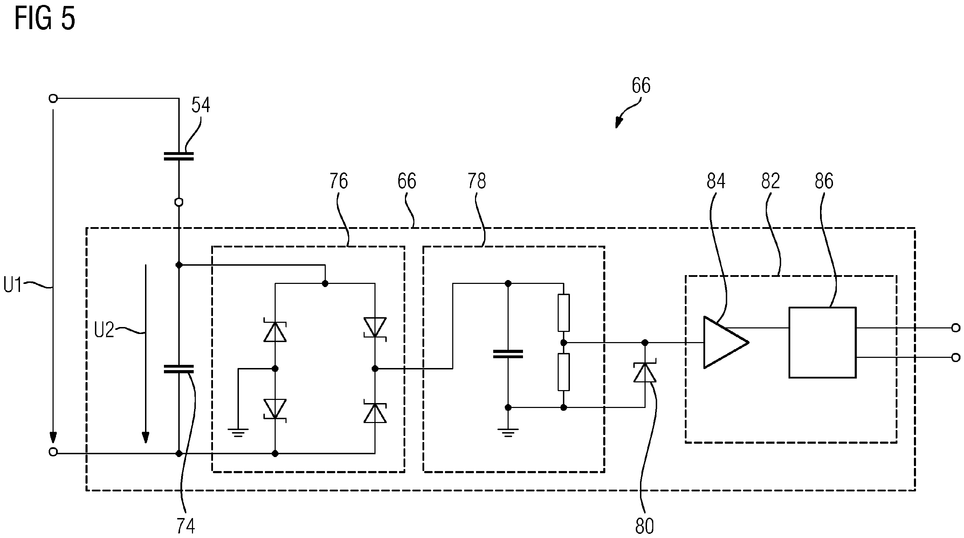

FIG 5 zeigt eine Schaltungsanordnung einer Zählvorrichtung 66 einer Überwachungsvorrichtung 40, wobei die Zählvorrichtung 66 als Impulszähler ausgeführt ist. Der Impulszähler weist einen in Serie zum ersten Kondensator 54 geschalteten zweiten Kondensator 74 auf, wobei der zweite Kondensator 74 als Niederspannungskondensator mit einer Kapazität im Bereich von 1 µF bis 10 µF ausgeführt ist. Die Kondensatoren 54, 74 bilden einen kapazitiven Spannungsteiler. Insbesondere bei einer Hochspannungsmaschine, welche mit einer Betriebsspannung ab 6,6 kV betreibbar ist, liegt, beispielsweise durch einen transienten Spannungsimpuls, kurzzeitig eine erste Spannung U1 von bis zu 80 kV an. Durch den kapazitiven Spannungsteiler beträgt der Spannungsabfall U2 am zweiten Kondensator 74 beispielsweise maximal 40 V. Die am zweiten Kondensator 74 abfallende zweite Spannung U2 wird durch einen Gleichrichter 76 gleichgerichtet, damit stromsparende und kostengünstige digitale Komponenten verwendbar sind. Der Gleichrichter 76 ist als Brückengleichrichter ausgeführt und weist Schottky-Dioden auf. Dem Gleichrichter 76 folgt ein analoges Tiefpassfilter 78, welches als RC-Tiefpassfilter ausgeführt ist, und beispielsweise zum Speichern des Scheitelwerts der Stoßspannung hinter dem Gleichrichter über eine ausreichende Zeit geeignet ist. Ein resistiver Spannungsteiler ermöglicht eine weitere Anpassung des Pegels. Ferner ist nach dem RC-Tiefpassfilter 78 eine Schutzdiode 80 angeordnet. Der Schutzdiode 80 folgt ein digitales Logikelement 82, insbesondere ein Mikrocontroller, welcher einen Schmitt-Trigger 84 und ein dahinter geschaltetes Flipflop 86, insbesondere ein asynchrones SR-Flipflop, umfasst. Der Schmitt-Trigger 84 funktioniert als Schwellenwertschalter. Alternativ wird ein Komparator verwendet. Das Flipflop 86 sorgt dafür, dass das transiente Spannungsimpulssignal gehalten wird, sodass eine langsamere und stromsparendere Logik verwendbar ist. Nach dem Flipflop 86 wird das Signal weiterverarbeitet und zusammen mit einem Zeitstempel gespeichert.

Zusammenfassend betrifft die Erfindung eine Vorrichtung 39 zur Erfassung einer Anzahl von transienten Spannungsimpulsen, insbesondere auf einer Spannungsversorgung. Um eine Vorrichtung für Spannungen im Kilovoltbereich anzugeben, die, im Vergleich zum Stand der Technik, einfach, robust und kostengünstig ist, wird vorgeschlagen, dass sie einen Stützisolator 34 mit wenigstens einem ersten Anschluss 46 und einem Messanschluss 52 aufweist, wobei wenigstens ein erster Kondensator 54 zwischen dem ersten Anschluss 46 und dem Messanschluss 52 angeschlossen ist und wobei eine Überwachungsvorrichtung 40 am Messanschluss 52 kontaktiert ist, welche eine Zählvorrichtung 66 zur Erfassung einer Anzahl von Spannungsimpulsen oberhalb einer vorgegebenen Spannungsschwelle umfasst.

## Patentansprüche

1. Vorrichtung (39) zur Erfassung einer Anzahl von transienten Spannungsimpulsen, insbesondere auf einer Spannungsversorgung, aufweisend einen Stützisolator (34) mit wenigstens einem ersten Anschluss (46) und einem Messanschluss (52), wobei wenigstens ein erster Kondensator (54) zwischen dem ersten Anschluss (46) und dem Messanschluss (52) angeschlossen ist und
wobei eine Überwachungsvorrichtung (40) am Messanschluss (52) kontaktiert ist,
welche eine Zählvorrichtung (66) zur Erfassung einer Anzahl von Spannungsimpulsen oberhalb einer vorgegebenen Spannungsschwelle umfasst.

2. Vorrichtung (39) nach Anspruch 1,
wobei der Stützisolator (34) einen zweiten Anschluss (60) umfasst,
wobei wenigstens eine Überspannungsschutzkomponente (58) zwischen dem Messanschluss (52) und dem zweiten Anschluss (60) angeschlossen ist.

3. Vorrichtung (39) nach Anspruch 2,
wobei die wenigstens eine Überspannungsschutzkomponente (58) in den Stützisolator (34) integriert ist.

4. Vorrichtung (39) nach einem der vorherigen Ansprüche, wobei die Überwachungsvorrichtung (40) Mittel zur Zuweisung eines Zeitstempels zu den jeweiligen Spannungsimpulsen aufweist.

5. Vorrichtung (39) nach einem der vorherigen Ansprüche, wobei die Zählvorrichtung (66) einen zweiten Kondensator (74) umfasst, welcher mit dem ersten Kondensator (54) einen kapazitiven Spannungsteiler bildet.

6. Vorrichtung (39) nach einem der vorherigen Ansprüche, wobei die Zählvorrichtung (66) Mittel zur digitalen Signalverarbeitung umfasst.

7. Vorrichtung (39) nach einem der vorherigen Ansprüche, wobei die Mittel zur digitalen Signalverarbeitung einen Schmitt-Trigger (84) und/oder einen Komparator umfassen.

8. Vorrichtung (39) nach einem der vorherigen Ansprüche, wobei die Überwachungsvorrichtung (40) eine Datenspeichervorrichtung (68) und/oder eine Energiespeichervorrichtung (70) aufweist.

9. Vorrichtung (39) nach einem der vorherigen Ansprüche, wobei die Überwachungsvorrichtung (40) über eine Steckverbindung lösbar kontaktiert ist.

10. Elektrische rotierende Maschine (2) mit mindestens einer Vorrichtung (39) nach einem der Ansprüche 1 bis 9.

11. Elektrische rotierende Maschine (2) nach Anspruch 10, wobei die mindestens eine Vorrichtung (39) in einem Klemmkasten (26) angeordnet ist.

12. Verfahren zur Erfassung einer Anzahl von transienten Spannungsimpulsen, insbesondere auf einer Spannungsversorgung, an einem Stützisolator (34),
welcher wenigstens einen ersten Anschluss (46 und einen Messanschluss (52) aufweist,
wobei wenigstens ein erster Kondensator (54) zwischen dem ersten Anschluss (46) und dem Messanschluss (52) angeschlossen ist,
wobei eine Überwachungsvorrichtung (40) am Messanschluss (52) kontaktiert wird, welche eine Zählvorrichtung (66) umfasst, wobei von der Zählvorrichtung (66) eine Anzahl von Spannungspulsen, welche einen vorgegebenen Wert überschreiten, ermittelt wird.

13. Verfahren nach Anspruch 12,
wobei zu den jeweiligen Spannungsimpulsen ein Zeitstempel zugeordnet wird.

14. Verfahren nach einem der Ansprüche 12 oder 13,
wobei Spannungspulse digital gezählt und deren Anzahl gespeichert wird.

15. Verfahren nach einem der Ansprüche 12 bis 14,
wobei die Überwachungsvorrichtung (40) über eine Steckverbindung lösbar kontaktiert wird.

16. Steuervorrichtung (72) zur Durchführung eines Verfahrens nach einem der Ansprüche 12 bis 15.
